# EUROPEAN PATENT APPLICATION

(11) **EP 4 686 353 A1**
(43) Date of publication of application: **28.01.2026**
(21) Application number: 25180629.5
(22) Date of filing: 04.06.2025
(51) Int. Cl.: H10H 29/855

(54) **DISPLAY DEVICE USING LIGHT EMITTING DEVICE**

(30) Priority: 22.07.2024 KR 20240096229
(71) Applicant: LG Electronics Inc., Yeongdeungpo-gu Seoul 07336 (KR)
(72) Inventor: SON, Kyungsoo, Seoul (KR); LEE, Jihoon, Seoul (KR); CHA, Seunghwan, Seoul (KR); KIM, Hyunjong, Seoul (KR); CHOI, Jeongsik, Seoul (KR)
(74) Representative: Vossius & Partner Patentanwälte Rechtsanwälte mbB

(57) **Abstract**

The present disclosure is applicable to a display device-related technical field, and relates to, for example, a display device using an LED (Light emitting device). A display device according to one embodiment of the present disclosure may include: a wiring board; a plurality of electrode pads disposed on the wiring board to define a plurality of unit sub-pixels; a plurality of light emitting devices electrically connected to the electrode pads to constitute the pixels; an encapsulation layer disposed on the light emitting devices; and a light control layer disposed on a side end of the encapsulation layer.

## Description

### CROSS-REFERENCE TO RELATED APPLICATIONS

The present application claims the benefits of priority to Korean Patent Application No. 10-2024-0096229, filed on July 22, 2024.

### The Background

### 1. The field

The present disclosure is applicable to a technical field related to display devices, and for example, relates to a display device using an LED (Light emitting device).

### 2. Description of the related art

Recently, display devices having excellent characteristics such as thinness and flexibility have been developed in the field of display technology. Currently, the major commercialized displays are represented by LCD (Liquid Crystal Display) and OLED (Organic Light Emitting Diode).

Meanwhile, a light emitting device (LED) is a semiconductor light emitting device that is well known for converting current into light, and since the commercialization of a red LED using a GaAsP compound semiconductor in 1962, it has been used as a light source for display images in electronic devices including information and communication devices along with a green LED of the GaP:N type. Recently, these light emitting devices (LEDs) have been gradually miniaturized and manufactured into micrometer-sized LEDs, which are used as pixels or flat lighting for display devices.

This micro-LED technology shows the characteristics of low power, high brightness, and high reliability compared to other display devices/panels, and may also be applied to flexible devices. Therefore, it has been actively studied by research institutes and companies recently.

A display device using these LEDs may be implemented by combining multiple display modules. When implementing a display device by combining display modules in this way, there may be cases where the light emitted from the light source located at the outermost part of the module is not visible from the outside.

For example, this may occur when looking at the display device from the side. This phenomenon occurs because a specific light among the light from the red, green, and blue light emitting devices is not visible, and this may be called a color fading (extinction) phenomenon.

Therefore, a solution that may solve this problem is required.

### The Summary

One embodiment of the present disclosure is to provide a display device using a light emitting device in which light emitted from a light emitting device located at the outermost end of a side of a display device is not totally reflected but can be normally emitted.

One embodiment of the present disclosure is to provide a display device in which light emitted from a light emitting device located at the outermost end of each module is not totally reflected but can be normally emitted when a plurality of display modules are combined to implement a display device.

Accordingly, the present disclosure is to provide a display device in which the phenomenon of light diffraction can be alleviated or eliminated when viewing the display device from the front and at a viewing angle, and in which light distribution can be evenly achieved.

A display device according to one embodiment of the present disclosure may include: a wiring board; a plurality of electrode pads disposed on the wiring board to define a plurality of unit sub-pixels; a plurality of light emitting devices electrically connected to one of the electrode pads to constitute the pixels; an encapsulation layer disposed on the light emitting devices; and a light control layer disposed at a side end of the encapsulation layer.

In addition, the light control layer may control a transmittance of light emitted from a first light emitting device of the plurality of light emitting devices at the side end of the encapsulation layer.

In addition, the first light emitting device may be disposed adjacent to the side end of the encapsulation layer.

In addition, the light control layer may reduce a ratio of light from the first light emitting device adjacent to the side end of the encapsulation layer being totally reflected at the side end of the encapsulation layer.

In addition, the light control layer may include a first layer having a first refractive index, a second layer having a second refractive index on the first layer and a third layer having a third refractive index on the second layer.

In addition, at least one of the first to third layers may have a refractive index between refractive indices of the encapsulation layer and air.

In addition, the third refractive index may be the same as the first refractive index.

In addition, the first refractive index of the first layer may be smaller than the refractive index of the encapsulation layer.

In addition, the second refractive index of the second layer may be greater than the refractive index of the encapsulation layer.

In addition, the light control layer may have an odd number layer which has a different refractive index from other layers.

A display device according to one embodiment of the present disclosure may be a display device in which a first module and a second module, each of which defines a plurality of unit pixel areas, are combined with a boundary portion therebetween, wherein at least one of the first module or the second module may include a plurality of electrode pads disposed in the unit pixel area to define a plurality of unit sub-pixels; a plurality of light emitting devices electrically connected on one of the electrode pad; an encapsulation layer disposed on the light emitting devices; and a light control layer disposed on the boundary portion, at least a portion of which has a refractive index between the refractive index of the encapsulation layer and the refractive index of air.

In addition, the light control layer may regulate an emission of light from a light emitting device of the plurality of light emitting devices adjacent to the boundary.

In addition, a pitch of the unit pixel may be 1 mm or less.

In addition, the light control layer may have an odd number layer which has a different refractive index from other layers.

In addition, the light control layer may have a first layer having a first refractive index, a second layer having a second refractive index on the first layer and a third layer having a third refractive index on the second layer.

In addition, at least one of the first to third layers may have a refractive index between refractive indices of the encapsulation layer and air.

According to one embodiment of the present disclosure, the following effects are provided.

First, light emitted from the light emitting device located at the outermost end of a side surface of a display device can be normally emitted without being totally reflected.

When a display device is implemented by combining a plurality of display modules, light emitted from a light emitting device located at the outermost end of each module can be normally emitted without being totally reflected. Accordingly, when viewing the display device from the front and at a viewing angle, the phenomenon of light extinction can be alleviated or eliminated, and the light distribution can be evenly achieved.

Furthermore, according to another embodiment of the present disclosure, there are additional technical effects not mentioned herein. Those skilled in the art may understand the entire meaning of the specification and drawings.

### Brief description of the drawings

FIG. 1 is a cross-sectional schematic diagram showing a display device according to the first embodiment of the present disclosure.
FIG. 2 is a cross-sectional schematic diagram showing a display device according to the second embodiment of the present disclosure.
FIG. 3 is a diagram showing a path of light propagated between different media.
FIG. 4 is a schematic diagram explaining an extinction phenomenon and a light enhancement phenomenon by total reflection.
FIG. 5 is a schematic diagram explaining an operation of the light control layer of the display device according to the first embodiment of the present disclosure.
FIG. 6 is a schematic diagram explaining the path of light when the light control layer has a different refractive index distribution from the first embodiment of the present disclosure as a comparative example.
FIG. 7 is a schematic diagram for explaining the extinction phenomenon by individual light sources.
FIGS. 8 to 10 are schematic diagrams for explaining the extinction phenomenon according to pixel pitch.
FIGS. 11 to 14 are schematic diagrams for explaining the extinction phenomenon according to the positional relationship of adjacent modules.
FIG. 15 is a schematic diagram for explaining the extinction phenomenon according to the mixing of light from each light source between adjacent modules.
FIG. 16 is a schematic diagram for explaining the effect by the operation of the light control layer according to the embodiments of the present disclosure.

### The Detailed description

Hereinafter, the embodiments disclosed in the present disclosure will be described in detail with reference to the attached drawings, and regardless of the reference signs, identical or similar components will be given the same reference numerals and redundant descriptions thereof will be omitted. The suffixes "module" and "part" for components used in the following description are given or used interchangeably only for the convenience of writing the specification, and do not have distinct meanings or roles in themselves. In addition, when describing the embodiments disclosed in this specification, if it is judged that a specific description of related known technologies may obscure the gist of the embodiments disclosed in this specification, the detailed description thereof will be omitted. In addition, it should be noted that the attached drawings are only intended to facilitate easy understanding of the embodiments disclosed in this specification, and that the technical ideas disclosed in this specification should not be construed as being limited by the attached drawings.

Furthermore, although each drawing is described for convenience of explanation, it is within the scope of the present disclosure that a person skilled in the art may implement another embodiment by combining at least two or more drawings.

In addition, when an element such as a layer, region, or substrate is mentioned as existing "on" another component, it will be understood that this may be directly on the other element or an intermediate element may exist between them.

The semiconductor light emitting device mentioned in this specification includes a concept such as an LED, a micro-LED, etc., and may be used interchangeably.

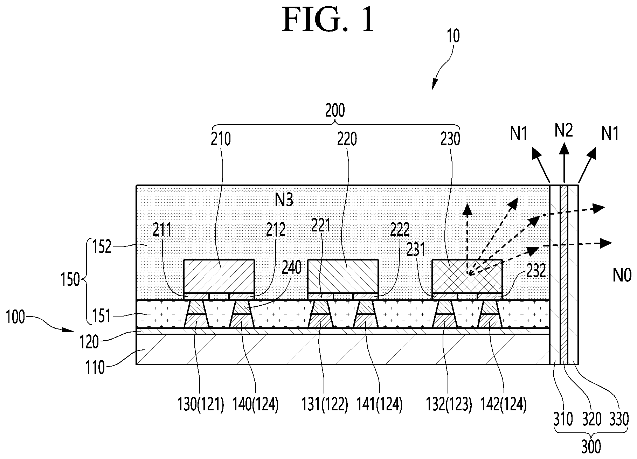

FIG. 1 is a cross-sectional schematic diagram showing a display device according to the first embodiment of the present disclosure. Referring to FIG. 1, the display device (10) may be configured such that individual unit pixel areas (200) are defined on a wiring board (100), and a plurality of light emitting devices (210, 220, 230) forming a unit light source are installed within the unit pixel areas (200).

Here, the individual light emitting devices (210, 220, 230) installed in the unit pixel areas (200) may substantially correspond to sub-pixels. For example, three sub-pixels may be gathered to form one pixel. In FIG. 1, the three light emitting devices (210, 220, 230) may correspond to red, green, and blue light emitting devices, respectively.

Each light emitting device (210, 220, 230) may be electrically connected to a pair of electrode pads (130, 140/131, 141/132, 142). In this case, for example, the electrode pads (130, 131, 132: hereinafter, the first electrode pads) disposed in one direction in FIG. 1 may be connected to the first wiring electrodes (121, 122, 123; signal electrodes or data electrodes). In addition, the electrode pads (140, 141, 142: hereinafter, the second electrode pads) disposed in the other direction may be connected to the second wiring electrodes (124; common electrode or scan electrode). However, the opposite case is also possible. In FIG. 1, the signal electrodes (121, 122, 123) and the common electrode (124) may be omitted in terms of the arrangement of the electrodes and electrode pads. Meanwhile, in some cases, the first electrode pad (130, 131, 132) may correspond to the signal electrode (121, 122, 123), and the second electrode pad (140, 141, 142) may correspond to the common electrode (124).

Hereinafter, the reference signs of the electrode pad and the wiring electrode are described interchangeably. That is, the electrode pad and the wiring electrode may be described using the same reference signs.

In this way, a unit sub-pixel may be defined at the point where the first wiring electrode (121, 122, 123) and the second wiring electrode (124) intersect each other. Meanwhile, when the light emitting devices (210, 220, 230) are driven in an Active Matrix (AM) manner, and when the first wiring electrode (121, 122, 123) is a signal electrode (or data electrode), the first wiring electrode (121, 122, 123, or the first electrode pad (130, 131, 132)) may be connected to a TFT layer (120) equipped with a thin film transistor (TFT). Accordingly, each light emitting device (210, 220, 230) may be driven by switching driving by the TFT layer (120).

In FIG. 1, although the TFT layer (120) is briefly indicated as a layer, the TFT layer (120) may include a plurality of TFT regions capable of performing a switching operation. For example, each TFT region may include a gate electrode, a source electrode, a drain electrode, an insulating layer disposed therebetween, a via electrode that may be connected to a first wiring electrode (121, 122, 123, or a first electrode pad (130, 131, 132)), etc. A detailed description thereof will be omitted. Each of these TFT regions may be connected to each of the light emitting devices (210, 220, 230).

A plurality of light emitting devices (200; 210, 220, 230) may be electrically connected on these wiring electrodes (121, 122, 123, 124) to form individual sub-pixels and be installed. Meanwhile, if the light emitting devices (210, 220, 230) are driven in a passive matrix (PM) manner, the TFT layer (120) may be omitted.

As mentioned above, the unit pixel (200) may include a red light emitting device (210), a green light emitting device (220), and a blue light emitting device (230), and these three light emitting devices (210, 220, 230) may form individual sub-pixels and be repeatedly disposed on the wiring board (100). The light emitting devices (210, 220, 230) may include at least one of an organic light emitting device or an inorganic light emitting device. For example, the light emitting devices (210, 220, 230) may be inorganic semiconductor light emitting devices (Light emitting devices; LEDs). For example, such semiconductor light emitting devices (LEDs; 200) may have a size in the order of millimeters (mm) or micrometers (µm). Here, the size in the order of micrometers (µm) may mean that at least one side of the light emitting device (200) has a size of several to several hundred micrometers (µm). The light emitting devices (210, 220, 230) may each include a first type electrode (for example, an n-type electrode; 211, 221, 231) and a second type electrode (for example, a p-type electrode; 212, 222, 232). These first type electrodes (211, 221, 231) and second type electrodes (212, 222, 232) may be electrically connected to a pair of electrode pads (130, 140/131, 141/132, 142) by solder (240).

In this way, a coating layer (150) may be disposed on the wiring board (100) on which the light emitting devices (210, 220, 230) are disposed. This coating layer (150) may perform at least one of the functions of an insulating layer that insulates the electrical connection portions of the light emitting devices (210, 220, 230) and a function of flattening the installation portions of the light emitting devices (210, 220, 230). The coating layer (150) may include a black coating layer (151) disposed on the wiring board (100) and covering at least a portion of the light emitting device (210, 220, 230). The black coating layer (151) may have a height corresponding to at least a portion of the side portion of the light emitting device (210, 220, 230). For example, the black coating layer (151) may cover at least a portion of the side portion of the light emitting device (210, 220, 230). For example, as illustrated in FIG. 1, an upper surface of the black coating layer (151) may be disposed at a certain height that does not completely cover the side portion of the light emitting device (210, 220, 230). The black coating layer (151) may improve the contrast ratio of the display device (10). That is, the black coating layer (151) may improve the black color of the display device (10).

For example, the material of the black coating layer (151) may be formed by mixing black powder with at least one of silicone, acrylic, urethane, and epoxy polymers. A thickness of the black coating layer may be smaller than thickness of the light emitting device (210, 220, 230) (for example, 150 µm or less).

The transmittance of the black coating layer (151) may be 80% or less. For example, when the transmittance exceeds 80%, the black color improvement effect may be low.

The black powder included in the black coating layer (151) may include an organic or inorganic dye, pigment (carbon black, etc.). The shape of the black powder may be spherical or amorphous.

The diameter of the black powder may be 10 nm to 20 µm. As described above, the coating layer (150) may serve as an insulating layer that insulates the electrical connection portions of the light emitting devices (210, 220, 230). At this time, the black coating layer (151) included in the coating layer (150) may also serve as an insulating layer that insulates the electrical connection portions of the light emitting devices (210, 220, 230). In addition, the black coating layer (151) may prevent the electrode pads (130, 140/131, 141/132, 142) made of a metal material from being reflected by external light and emitting reflected light. The coating layer (150) may include an encapsulation layer (152) disposed on the black coating layer (151). The encapsulation layer (152) may be provided with at least one of the roles of a transparent layer through which light emitted from the light emitting device (210, 220, 230) is transmitted, a flattening layer, a scattering layer, and a role of preventing damage due to external force.

The encapsulation layer (152) may be manufactured using at least one of silicone, acrylic, urethane, and epoxy polymers. The encapsulation layer (152) may include filler particles (not shown). The filler particles may act as a light scattering agent. Meanwhile, a separate scattering layer including a light scattering agent may be provided separately from the encapsulation layer (152). A thickness of the encapsulation layer (152) or the scattering layer may be 20 µm. The thickness of the encapsulation layer (152) may be 300 µm or less.

The filler particles may have optical properties that refract or scatter light emitted from the light emitting device (210, 220, 230). Light emitted from the light emitting device (210, 220, 230) may be refracted or scattered by at least one of the encapsulation layer (152) and the filler particles. Light scattered by the filler particles may be emitted to the outside of the coating layer (150).

The encapsulation layer (152) may have light-transmitting properties after being cured. For example, the encapsulation layer (152) cured including silicon may have a refractive index of 1.4 to 1.6. Accordingly, light may be totally reflected inside the encapsulation layer (152). The filler particles may refract or scatter light totally reflected inside the encapsulation layer (152).

In this way, the filler particles may act as a light scattering agent. Therefore, the filler particle may be referred to as a light scattering agent. In the following description, the filler particles and the light scattering agent may mean the same entity. The color viewing angle of the display device (10) may be improved by mixing such light scattering agents. In addition, filler particles having a high scattering effect with a small amount of light scattering agents may be used.

The filler particles may include at least one of Zr, Si, Ti, Zn, BaS, and oxides thereof. For example, the filler particles may be spherical or amorphous. The diameter of the filler particles may be 20 nm to 7 µm based on D50 (medium size).

At least one end (boundary) of such a display device (10) may be provided with a light control layer (300). This light control layer (300) may control an optical characteristic of light emitted from at least one of the light emitting devices (210, 220, 230). For example, the light control layer (300) may reduce the ratio of light emitted from at least one of the light emitting devices (210, 220, 230) to be totally reflected at the boundary surface of the encapsulation layer (152).

For example, the light control layer (300) may control the light emission of the light emitting device (230; in this case, a blue light emitting device) adjacent to the end of the encapsulation layer (152) where the light control layer (300) is located.

For example, the light control layer (300) may control the transmittance of light emitted from the light emitting device (230) adj acent to the side end (boundary) of the encapsulation layer (152). Here, the side end of the encapsulation layer (152) may mean an end in a direction perpendicular to the light emitting surface formed by the unit pixel (200). As an exemplary embodiment, the light control layer (300) may have a multilayer structure at the lateral end of the encapsulation layer (152). Referring to FIG. 1, the light control layer (300) may include a first layer (310), a second layer (320), and a third layer (330).

Here, the first layer (310) may have a first refractive index (N1). The second layer (320) may have a second refractive index (N2). The third layer (330) may have the same first refractive index (N1) as the first layer (310).

As an example, the light control layer (300) may have a multilayer structure of low refractive layers (310, 330) and high refractive layer (320). At this time, the multilayer structure may include an odd number of layers. As an exemplary embodiment, the difference in refractive index between the low-refractive layer (310, 330) and the high-refractive layer (320) may be 0.3 or more.

At least one layer among the layers forming the light control layer (300) may have a refractive index between the refractive index (N3) of the encapsulation layer (152) and the refractive index (N0) of Air.

As an exemplary embodiment, the refractive index (N3) of the encapsulation layer (152) may be 1.5. For example, the first layer (310) and the third layer (330) of the light control layer (300) may have refractive indices between 1 (the refractive index of air) and 1.5. For example, the refractive index of the low-refractive layer (310, 330) may be 1.1 to 1.3. For example, the refractive index of the high-refractive layer (320) may be 1.5 to 1.8. For example, the refractive index of the first layer (310) may be smaller than the refractive index (N3) of the encapsulation layer (152). At this time, for example, the refractive index of the second layer (320) may be greater than the refractive index (N3) of the encapsulation layer (152).

The layers forming the light control layer (300) may be formed by pad printing or deposition. For example, pad printing may include a process of forming a wet coating layer on the lateral end of the encapsulation layer (152) and then curing it. For example, the deposition method may include a process of performing E-beam deposition or sputter deposition on the lateral end of the encapsulation layer (152).

For example, the thickness of each layer forming the light control layer (300) may be 1 to 10 µm. In this case, the light control layer (300) may be formed by pad printing.

In another example, the thickness of each layer forming the light control layer (300) may be 10 to 200 nm. This case may correspond to the case where the light control layer (300) is implemented by a deposition method.

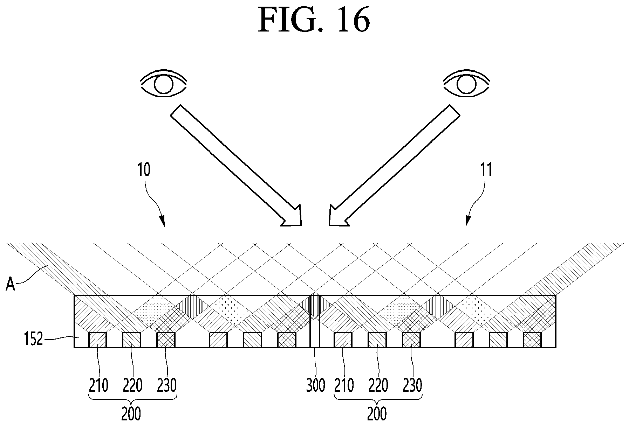

Although not separately illustrated in FIG. 1, a modular display device may be implemented in which a plurality of display devices (10) are combined to implement a wider display area. For example, the display device (10) may be one display module forming a modular display device. In this way, a plurality of display devices (10) may be combined in parallel to form a modular display device (see FIG. 16). Hereinafter, the display device (10) and the display module (10) will be described interchangeably using the same reference signs.

In this way, when a plurality of unit display modules (10) in which a plurality of unit pixel areas (200) are defined are combined to form a wider display device, the plurality of display modules may be combined with each other with a boundary between them. For example, two unit display modules (10) may be connected adjacent to each other. For example, a first module (10) and a second module (11; see FIG. 16) in which a plurality of unit pixel areas (200) are defined may be combined with a boundary therebetween to implement a display device. The display modules (10, 11) combined with the boundary therebetween may be repeatedly and/or continuously combined. These display modules (10, 11) may have a structure as described above. For example, the display module (10, 11) may include electrode pads (130, 131, 132/140, 141, 142) disposed in a unit pixel area to define a plurality of unit sub-pixels, a light emitting device (210, 220, 230) electrically connected to one of the electrode pads (130, 131, 132/140, 141, 142), and a light control layer (300) disposed on a boundary and having a refractive index at least partially between the refractive index of the encapsulation layer (152) and the refractive index of air. In this case, a boundary may be disposed between the two unit display modules (10, 11). At this time, the display device is configured so that the two boundary portions are ideally in complete contact with each other, but in practice, an air gap may be disposed. Therefore, the refractive index of air may be considered (N0). Alight control layer (300) may be provided at the boundary between such display devices (10, 11). This light control layer (300) may control the optical characteristics of light emitted from at least one of the light emitting devices (210, 220, 230).

As described above, for example, the light control layer (300) may reduce the ratio of light emitted from at least one of the light emitting devices (210, 220, 230) to total reflection at the boundary surface of the encapsulation layer (152).

For example, the light control layer (300) may control the emission of light from the light emitting device (230; in this case, a blue light emitting device) adjacent to the end (boundary) of the encapsulation layer (152) where the light control layer (300) is located. For example, the light control layer (300) may control the transmittance of light emitted from the light emitting device (230) adjacent to the boundary of the display device (10, 11). Here, the boundary of the display device (10, 11) may mean an end in a direction perpendicular to the light emitting surface formed by the unit pixel (200).

As an exemplary embodiment, the light control layer (300) may have a multilayer structure at the boundary of the display device (10, 11). Referring to FIG. 1, the light control layer (300) may include a first layer (310), a second layer (320), and a third layer (330).

Here, the first layer (310) may have a first refractive index (N1). The second layer (320) may have a second refractive index (N2). The third layer (330) may have the same first refractive index (N1) as the first layer (310).

For example, the light control layer (300) may have a multilayer structure of low refractive layers (310, 330) and high refractive layer (320). At this time, the multilayer structure may include an odd number of layers. As an exemplary embodiment, the difference in refractive index between the low refractive layer (310, 330) and the high refractive layer (320) may be 0.3 or more.

At least one layer among the layers forming the light control layer (300) may have a refractive index between the refractive index (N3) of the encapsulation layer (152) and the refractive index (N0) of air. For example, the refractive index (N3) of the encapsulation layer (152) may be 1.5. At this time, the first layer (310) and the third layer (330) of the light control layer (300) may have a refractive index between 1 (refractive index of air) and 1.5.

For example, the refractive index of the first layer (310) may be smaller than the refractive index (N3) of the encapsulation layer (152). At this time, for example, the refractive index of the second layer (320) may be greater than the refractive index (N3) of the encapsulation layer (152).

In this way, when implementing a display device by combining display modules, there may be cases where light emitted from a light source located at the outermost part of the module is not visible from the outside. For example, this may occur when viewing the display device from the side. This may be caused by total reflection occurring due to a difference in refractive index at a specific angle of the edge portion including the side end of the module. As a result, when viewing the display device, an issue may occur where some colors of light are not visible at a specific angle, resulting in a color change. This is a phenomenon that occurs because a specific light among the light from the red, green, and blue light emitting devices is not recognized, and this may be called a color fading (extinction) phenomenon.

The cause of this phenomenon is that the light emitted from the light source (light emitting device) located at the outermost part of the module may cause total reflection inside the module due to a large refractive index difference (Δ0.5 or more) at a specific angle on the module edge. Therefore, in a situation where red, green, and blue should be mixed and white should be displayed at an upward angle of the display device, for example, the red light may be extinguished and a Cyan (Green + Blue) line may be displayed. On the other hand, in a situation where the blue light should be extinguished and white should be displayed at a downward angle of the display device, a phenomenon may occur where a yellow (Red + Green) line is displayed. However, according to one embodiment of the present disclosure described above, the light control layer (300) may alleviate the internal total reflection (or light brightening) phenomenon of the side end portion or the outermost portion of the module of the display device, thereby alleviating the color fading (light extinguishing) phenomenon. This will be described in detail later with reference to the drawings.

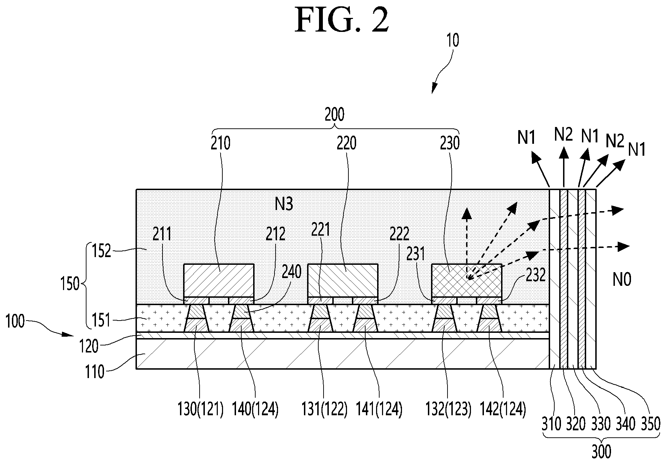

FIG. 2 is a cross-sectional schematic diagram showing a display device according to the second embodiment of the present disclosure.

Referring to FIG. 2, an example in which the light control layer (300) is modified is shown compared to the first embodiment of the present disclosure described with reference to FIG. 1 above. Therefore, redundant descriptions will be omitted and specific examples of the light control layer (300) will be mainly described.

The light control layer (300) may be provided on at least one end portion such as a boundary portion of the display device (10). This light control layer (300) may control the optical characteristics of light emitted from at least one of the light emitting devices (210, 220, 230). For example, the light control layer (300) may reduce the ratio of light emitted from at least one of the light emitting devices (210, 220, 230) being totally reflected at the boundary of the encapsulation layer (152) or the boundary between adjacent modules (10, 11).

For example, the light control layer (300) may control the light emission of the light emitting device (230; in this case, a blue light emitting device) adjacent to the end of the encapsulation layer (152) where the light control layer (300) is located or the boundary between two modules (10, 11).

For example, the light control layer (300) may control the transmittance of light emitted from the light emitting device (230) adjacent to the side end such as the boundary of the encapsulation layer (152). Here, the side end of the encapsulation layer (152) may mean the end in the direction perpendicular to the light emitting surface formed by the unit pixel (200). As an exemplary embodiment, the light control layer (300) may have a multilayer structure at the lateral end of the encapsulation layer (152).

Referring to FIG. 2, the light control layer (300) may include a first layer (310), a second layer (320), a third layer (330), a fourth layer (340), and a fifth layer (350). Here, the first layer (310) may have a first refractive index (N1). The second layer (320) may have a second refractive index (N2). The third layer (330) may have the same first refractive index (N1) as the first layer (310). As an exemplary embodiment, the first layer (310, the third layer (330), and the fifth layer (350) may have a first refractive index (N1). Meanwhile, the second layer (320) and the fourth layer (340) may have a second refractive index (N2).

For example, the light control layer (300) may have a multilayer structure including a low refractive layer (310, 330, 350) and a high refractive layer (320, 340). At this time, the multilayer structure may include an odd number of layers. In the present embodiment, the multilayer structure is exemplified as including five layers. However, it may include more odd numbers of layers. For example, the light control layer (300) may have a multilayer structure including seven or more layers.

As an exemplary embodiment, the difference in refractive index of the low refractive layer (310, 330, 350) and the high refractive layer (320, 340) may be 0.3 or more.

At least one layer among the layers forming the light control layer (300) may have a refractive index between the refractive index (N3) of the encapsulation layer (152) and the refractive index (N0) of Air.

As an exemplary embodiment, the refractive index (N3) of the encapsulation layer (152) may be 1.5. For example, the first layer (310), the third layer (330), and the fifth layer (350) of the light control layer (300) may have refractive indices between 1 (refractive index of air) and 1.5. For example, the refractive indices of the low-refractive-index layers (310, 330, 350) may be 1.1 to 1.3. For example, the refractive indices of the high-refractive-index layers (320, 340) may be 1.5 to 1.8.

For example, the refractive index of the first layer (310) may be smaller than the refractive index (N3) of the encapsulation layer (152). In this case, for example, the refractive index of the second layer (320) may be greater than the refractive index (N3) of the encapsulation layer (152).

The layers forming the same light control layer (300) may be formed by pad printing or deposition. For example, pad printing may include a process of forming a wet coating layer on the lateral end of the encapsulation layer (152) and then curing it. For example, the deposition method may include a process of performing E-beam deposition or sputter deposition on the lateral end of the encapsulation layer (152).

For example, the thickness of each layer forming the light control layer (300) may be 1 to 10 µm. This may correspond to a case where the light control layer (300) is implemented by pad printing.

For another example, the thickness of each layer forming the light control layer (300) may be 10 to 200 nm. This may correspond to a case where the light control layer (300) is implemented by deposition. Although not shown separately in FIG. 2, a modular display device may be implemented in which a plurality of display devices (10) are combined to implement a wider display area. Duplicate descriptions thereof will be omitted.

According to one embodiment of the present disclosure described above, the light control layer (300) may alleviate the internal total reflection (light brightening) phenomenon of the side end of the display device or the outermost part of the module, thereby alleviating the color fading (light extinguishing) phenomenon that may occur when viewing the display device from the side.

Hereinafter, the light brightening phenomenon that may occur at the boundary between display modules will be described in detail. Hereinafter, the effect of the light control layer according to embodiments of the present disclosure will be described.

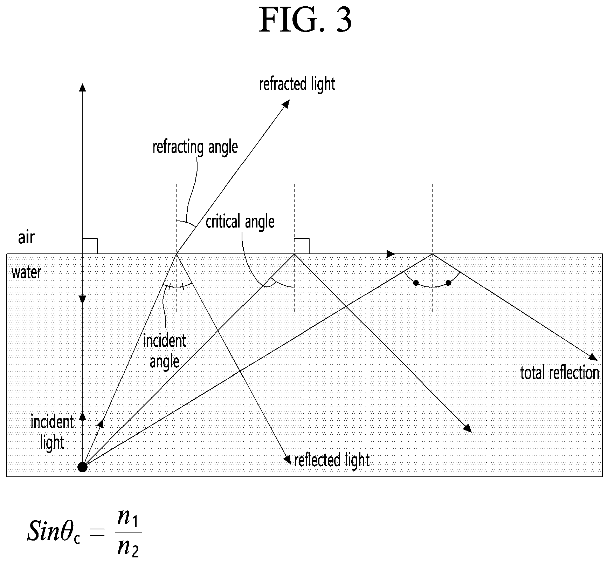

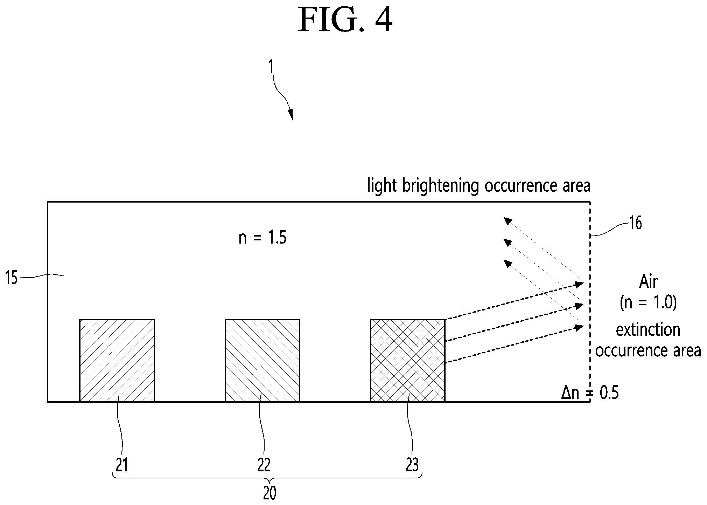

FIG. 3 is a diagram showing the path of light propagating between different media. FIG. 4 is a schematic diagram explaining the light extinction phenomenon and light brightening phenomenon due to total reflection.

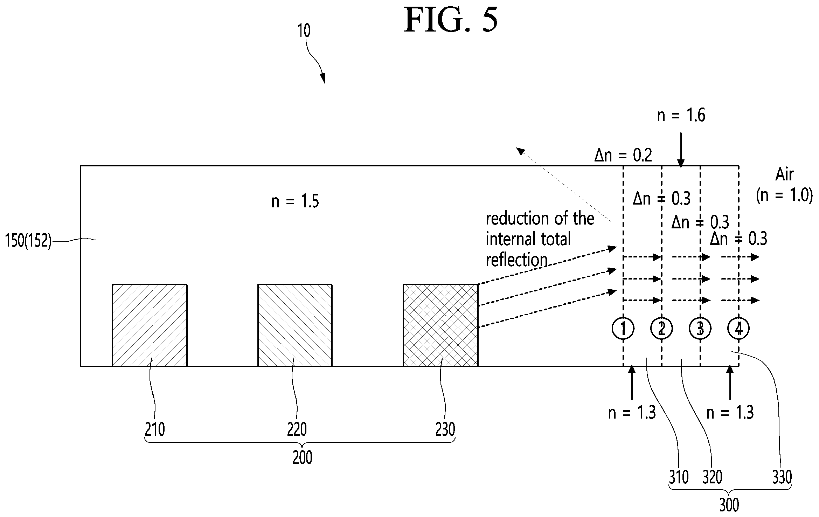

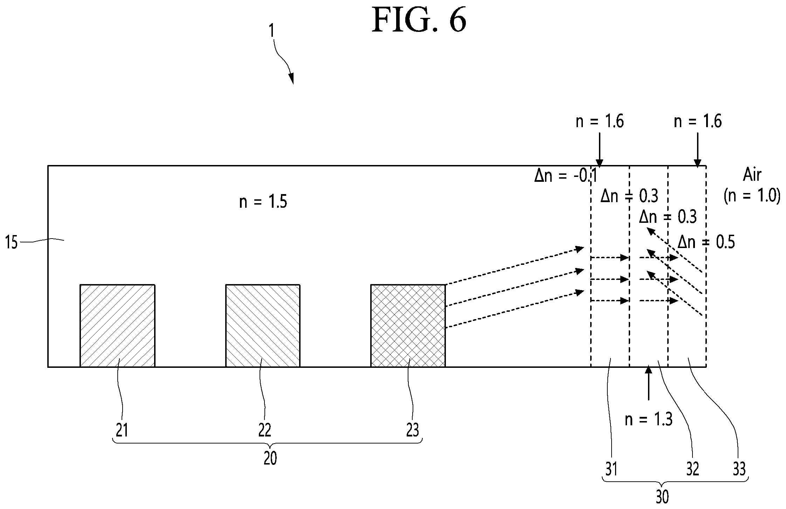

FIG. 5 is a schematic diagram explaining the operation of the light control layer of the display device according to the first embodiment of the present disclosure. FIG. 6 is a schematic diagram for explaining the path of light when the light control layer has a different refractive index distribution from the first embodiment of the present disclosure as a comparative example.

First, referring to FIG. 3, as a general case, the light propagation path between air and water is shown, but here, water may correspond to the encapsulation layer of the present disclosure.

The propagation of light between these two media may be explained by Snell's law. When light propagates from a region with a high refractive index (water or encapsulation layer) to a region with a low refractive index (air), some of the incident light may be refracted and propagated to another medium (refracted light) and some may be reflected depending on the angle formed at the boundary surface of the two media (reflected light).

At this time, when the incident angle of the incident light is greater than the critical angle (θc), the total reflection phenomenon occurs in which the light is not propagated to the neighboring medium and is entirely reflected into the medium. In general, the greater the difference in refractive index, the smaller the critical angle, so the total reflection phenomenon may occur at more angles. Referring to FIG. 4, such a total reflection phenomenon may occur at the side edge such as boundary of the display device (1) or the display module (1).

For example, the refractive index of the encapsulation layer (15) of a general display device (1) or display module (1) including a pixel area (20) including a red light source (21), a green light source (22), and a blue light source (23) may be 1.5 (n = 1.5) when a transparent resin is applied. At this time, when light is transmitted from the display device (1) or the display module (1) to an air layer (n = 1.0) having a refractive index of 1, the refractive index difference between the two media may be 0.5 or more.

In this case, total reflection may occur for most of the light propagation depending on the refractive index difference (0.5 or more) of the outermost interface (boundary; 16) of the module (10). Accordingly, the light emitted from the blue light source (for example, LED; 23) adjacent to the boundary (16) is not emitted outside the module (1) but is totally reflected, and an extinction phenomenon may occur in which the light from the blue light source (23) is not visible when viewed from the outside of the display device (1). For example, an extinction occurrence area occurs when the display device (1) is viewed from a viewing angle other than the front.

Since this totally reflected light may be emitted through the upper surface of the display device (1), a light brightening phenomenon in which the emitted light increases may occur on the upper surface near the boundary (16). In other words, a light brightening occurrence area may occur on the upper surface near the boundary (16).

Accordingly, as described above, in some directional angles of the display device (1), a phenomenon in which a yellow (red + green light brightening) line is visible may occur in a situation in which white should be visible because the blue light is extinguished. Meanwhile, referring to FIG. 5, the refractive index of the encapsulation layer (152) of the display device (10) or the display module (10) according to the embodiments of the present disclosure, which includes a pixel region (200) including a red light source (210; a light emitting device), a green light source (220), and a blue light source (230), may be 1.5 (n = 1.5) when a transparent resin is applied.

At this time, the light control layer (300) having the refractive index distribution described above may reduce the ratio of light emitted from at least one of the light emitting devices (210, 220, 230) being totally reflected at the boundary surface of the encapsulation layer (152).

For example, the light control layer (300) may control the emission of light from the light emitting device (230; in this case, a blue light emitting device) adjacent to the end of the encapsulation layer (152) where the light control layer (300) is located. For example, the light control layer (300) may control the transmittance of light emitted from the blue light emitting device (230) adjacent to the side end (boundary) of the encapsulation layer (152). That is, the light control layer (300) may reduce the total internal reflection of light emitted from the blue light emitting device (230) adjacent to the side end (boundary) of the encapsulation layer (152).
According to an embodiment of the present disclosure, for example, the refractive indices of the first layer (310) and the third layer (330) of the light control layer (300) are 1.3 (n = 1.3), and the refractive index of the second layer (320) is 1.6 (n = 1.6), so that the refractive index difference between the encapsulation layer (152) and the adjacent first layer (310) is 0.2 (Δn = 0.2). In addition, the refractive index difference of the second layer (320) compared to the first layer (310) and the third layer (330) constituting the light control layer (300) is 0.3 (Δn = 0.3).

In this case, the refractive index difference of the outermost interface (boundary) of the display device (10) or module (10) may be reduced to 0.3 or less, thereby reducing the occurrence of total reflection of light emitted from the blue light emitting device (230) adjacent to the boundary.

Specifically, the refractive index difference between the encapsulation layer (152) and the first layer (310) is 0.2 (Δn = 0.2), which may be reduced compared to the refractive index difference (Δn = 0.5) between the encapsulation layer (152) and the air layer. Accordingly, the internal total reflection phenomenon may be reduced. This may correspond to a kind of buffer function. Since the refractive index increases between the first layer (310) having a low refractive index and the second layer (320) having a high refractive index, the total internal reflection phenomenon may be reduced due to the refractive index inversion.

The refractive index difference between the second layer (320) and the third layer (330) is 0.3 (Δn = 0.3), which may be reduced compared to the refractive index difference (Δn = 0.6) between the second layer (320) having a high refractive index and the air. Accordingly, the total internal reflection phenomenon may be reduced.

The refractive index difference between the third layer (330) and the air is 0.3 (Δn = 0.3), which may be reduced compared to the refractive index difference (Δn = 0.5) between the encapsulation layer (152) and the air. Accordingly, the total internal reflection phenomenon may be reduced.

Accordingly, the extinction phenomenon in which the light of the blue light source (230) becomes invisible when viewed from the outside of the display device (10) may be resolved or reduced. For example, the extinction occurrence area may be reduced or eliminated when viewing the display device (10) from a viewing angle other than the front. Accordingly, the light brightening phenomenon may also be resolved or reduced on the upper surface near the boundary of the display device (10).

Referring to FIG. 6, the propagation of light by the light control layer (30) according to the comparative example having a different refractive index distribution from the light control layer (300) according to the embodiment of the present disclosure will be described.

Referring to FIG. 6, the first layer (31) adjacent to the encapsulation layer (15) has a high refractive index (1.6), the second layer (32) adjacent to the first layer (31) has a low refractive index (1.3), and the third layer (33) located thereafter has the same refractive index as the first layer (31). In this case, when light emitted from a blue light source (for example, LED; 23) adjacent to the light control layer (30) is transmitted from the encapsulation layer (15) to the first layer (31) having a high refractive index, the internal total reflection may decrease. However, in the subsequent structure (after the second layer (32)), the internal total reflection may rather increase. Finally, when transmitted to the air from the third layer (33) having a high refractive index, the internal total reflection phenomenon may be strengthened. Therefore, the light control layer (30) having the refractive index distribution shown in FIG. 6 is not suitable.

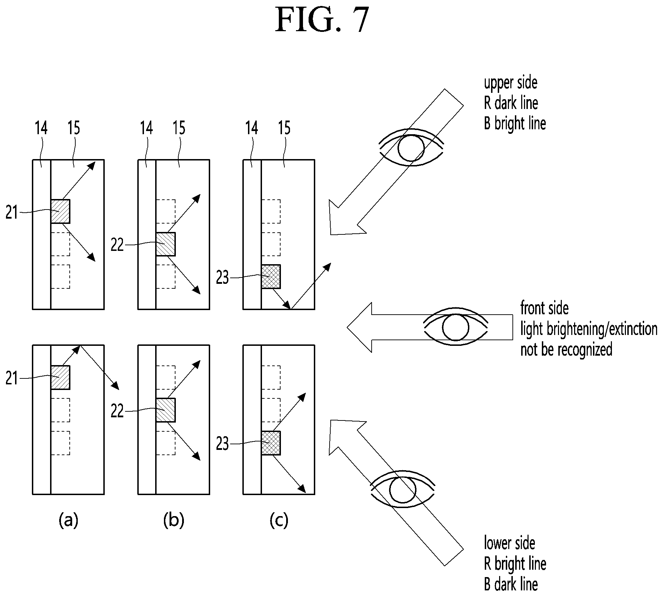

FIG. 7 is a schematic diagram for explaining the extinction phenomenon by individual light sources.

Referring to FIG. 7, when the light control layer (300) according to the embodiment of the present disclosure is not provided, the phenomenon according to the light emission of each light source (21) in the display device is shown. When a general display device (1) or display module (1) including a pixel area (20) including a red light source (21), a green light source (22), and a blue light source (23) are disposed in combination with each other, FIG. 7(a) shows a case where a red light source (21) is emitted, FIG. 7(b) shows a case where a green light source (22) is emitted, and FIG. 7(c) shows a case where a blue light source (23) is emitted.

First, when a red light source (21) is emitted as in FIG. 7(a), when viewed from the upper side, the red light may be extinguished by total reflection, resulting in a red (R) dark line. On the other hand, when viewed from the lower side, the red light may be brightened, resulting in a red (R) bright line.

On the other hand, when a green light source (22) is emitted as in (b), no special phenomenon may occur because the green light source (22) is not adjacent to the boundary. However, when a blue light source (23) emits light as in FIG. 7(c), when viewed from the upper side, the blue light may be brightened by total reflection, resulting in a blue (B) bright line. On the other hand, when viewed from the lower side, the blue light may be extinguished, resulting in a blue (B) dark line.

Meanwhile, when viewed from the front side, the light brightening/extinction may not be recognized. In this way, the light brightening/extinction may be a problem when looking at the display at a certain viewing angle.

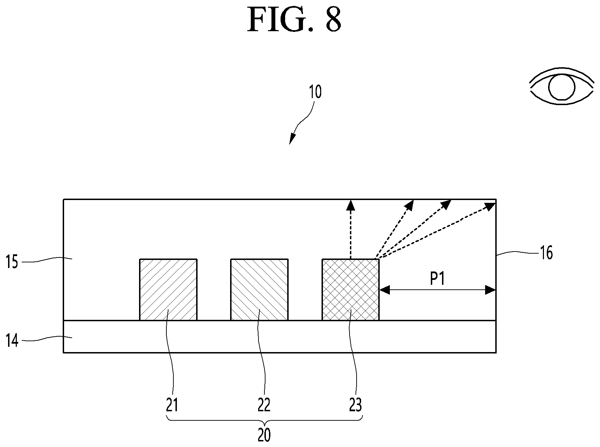

FIGS. 8 to 10 are schematic diagrams for explaining the light brightening/extinction phenomenon according to the pixel pitch.

Referring to FIGS. 8 to 10, it may be seen that the light brightening/extinction phenomenon described above occurs at a specific pixel pitch.

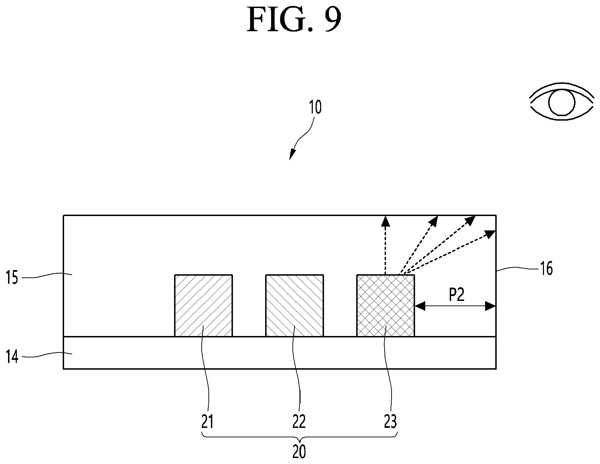

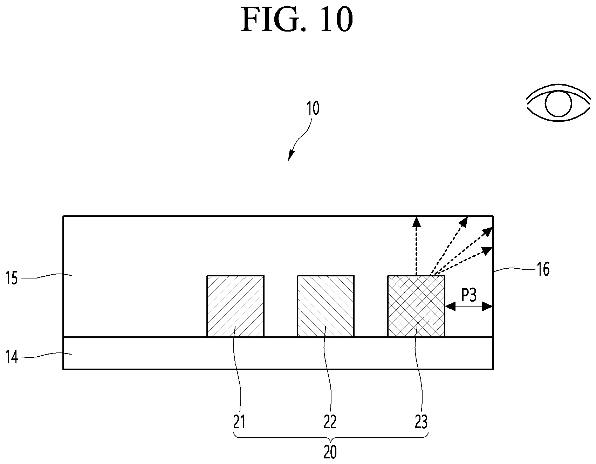

For example, FIG. 8 may correspond to a case where the pixel pitch is 1.25 mm, FIG. 9 may correspond to a case where the pixel pitch is 0.93, and FIG. 10 may correspond to a case where the pixel pitch is 0.78 or 0.68.

In this way, as the pixel pitch decreases, it may be seen that the distance between the outermost light source (23) close to the boundary (16) of the module (1) and the boundary (16) (hereinafter, the boundary distance) gradually decreases to P1, P2, and P3, respectively. Considering that light is mainly emitted upward from the light source and the limited angle of incidence, in the case of a pixel pitch such as FIG. 8, the light extinguishing may not be recognized. However, in the case of FIG. 9, the light extinguishing may be weakly recognized, and in the case of FIG. 10, the light extinguishing may be strongly recognized. In this way, it may be advantageous to consider the occurrence of the light extinguishing when the pixel pitch is 1 mm or less.

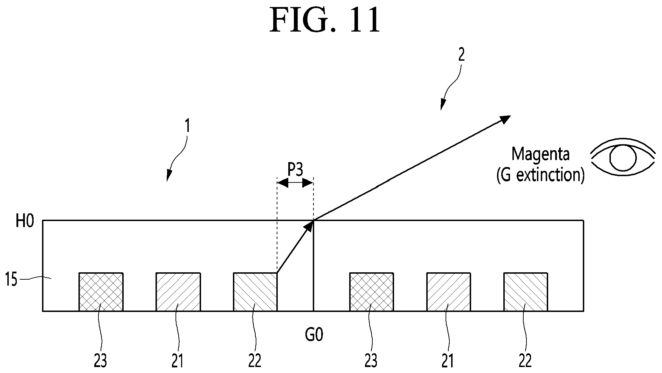

FIGS. 11 to 14 are schematic diagrams for explaining the light extinction phenomenon according to the positional relationship of adjacent modules.

Referring to FIGS. 11 to 14, it may be seen that the light extinction phenomenon described above occurs in a specific positional relationship between two modules (1, 2). FIGS. 11 to 14 correspond to the case of FIG. 10 where the pixel pitch is 0.78 or 0.68. Meanwhile, the arrangement of the light sources is explained as being disposed in the order of a blue light source (23), a red light source (21), and a green light source (22). Referring to FIG. 11, this corresponds to the case where the gap between the two modules (1, 2) is practically negligible (G0), the pixel pitch corresponds to P3, and there is no height difference between the two modules (1, 2) (H0).

In this case, the light emitted from the green light source (22) located at the outermost side of the module (1) on the left is extinguished at the boundary, so that magenta light may be seen when viewed from a position with a certain viewing angle in a situation where white light should be emitted.

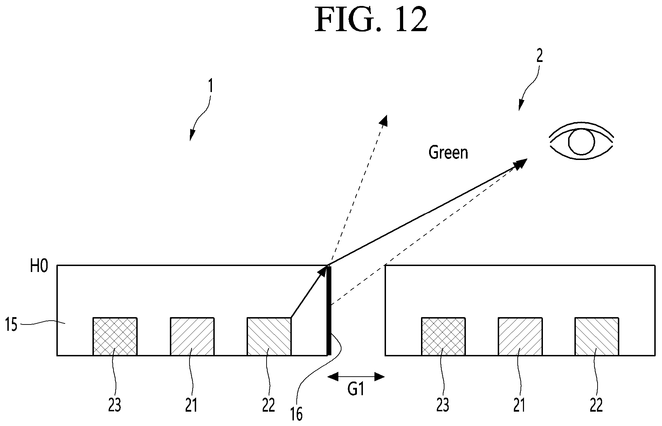

Referring to FIG. 12, this corresponds to the case where a certain gap (G1) occurs between the two modules (1, 2) and there is no height difference between the two modules (1, 2) (H0).

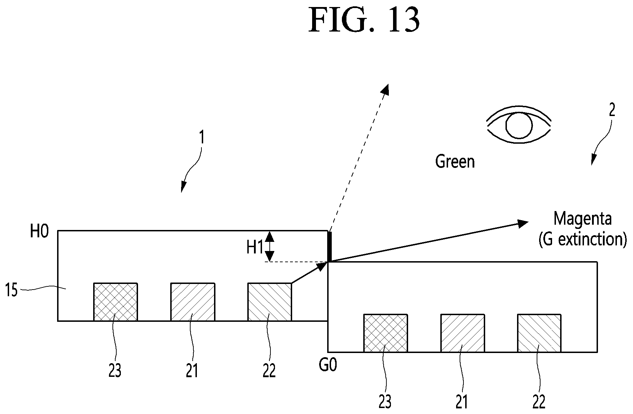

In this case, it may be seen that the light (Green) emitted from the green light source (22) located at the outermost side of the module (1) on the left is emitted as is through the boundary (16). Referring to FIG. 13, this corresponds to a case where the gap between the two modules (1, 2) is practically negligible (G0) and a height difference (H1) occurs between the two modules (1, 2).

In this case, light (Green) emitted from the green light source (22) relatively upward is emitted as is through the boundary (16), but light emitted from the green light source (22) relatively downward is extinguished at the boundary, so that magenta light may be seen in a situation where white light should be emitted.

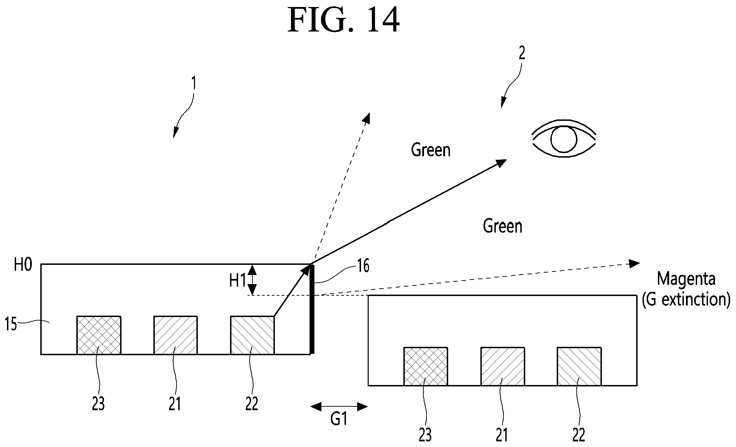

Referring to FIG. 14, this corresponds to a case where a certain gap (G1) occurs between the two modules (1, 2) and a height difference (H1) occurs between the two modules (1, 2). In this case, similar to the case of FIG. 13, light (Green) emitted from a green light source (22) relatively upward is emitted as is through the boundary (16), but light emitted from a green light source (22) relatively downward is extinguished at the boundary, so that magenta light may be seen in a situation where white light should be emitted.

As described above, if the light control layer (300) according to the embodiment of the present disclosure is not provided, a light brightening/extinction phenomenon may occur depending on the positional relationship between the two modules (1, 2) or light emitted from the light source located at the outermost side may be seen as it is.

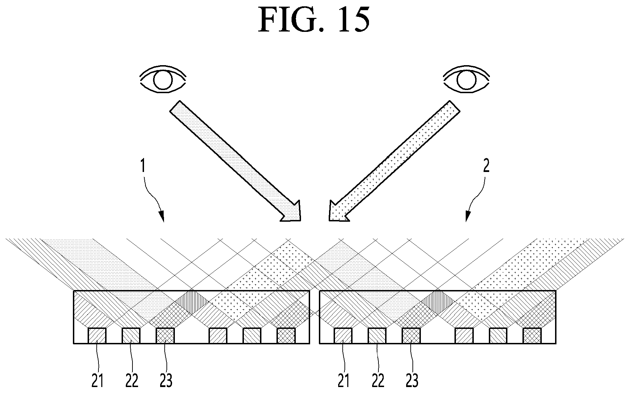

FIG. 15 is a schematic diagram explaining the extinction phenomenon due to mixing of light from each light source between adjacent modules. Referring to FIG. 15, a display device is shown in which a red light source (21), a green light source (22), and a blue light source (23) forming unit pixels are provided in the first module (1) and the second module (2), and the first module (1) and the second module (2) are combined to form a display device.

As described above, when implementing a display device by combining display modules, there may be cases where light emitted from a light source located at the outermost side of the module is not visible from the outside. For example, this case may occur when viewing the display device from the side. This is a phenomenon that occurs because a specific light among the light from the red, green, and blue light emitting devices is not visible, and this may be referred to as a color fading (extinction) phenomenon.

The cause of this phenomenon is that light emitted from the blue light emitting device (23) and the red light emitting device (21) located at the outermost side of the module may cause total reflection inside the module due to a large refractive index difference (Δ0.5 or more) at a specific angle on the module edge side. Therefore, in a situation where red, green, and blue should be mixed to show white at an upper angle on the side of the first module (1), for example, red light may be extinguished and a Cyan (Green + Blue enhancement) line may be visible. On the other hand, in a situation where blue light should be extinguished and white should be shown at a lower angle on the side of the second module (2), a phenomenon may occur where a yellow (Yellow + Green enhancement) line may be visible.

FIG. 16 is a schematic diagram for explaining the effect of the light control layer according to embodiments of the present disclosure.

FIG. 16 shows an example where the light extinction phenomenon described above is resolved by the light control layer (300), and white is normally shown when viewed from a side angle of the first module (10) and the second module (11).

According to one embodiment of the present disclosure described above, the light control layer (300) may alleviate the internal total reflection (light brightening) phenomenon of the side end or the outermost part of the module of the display device, thereby alleviating the color fading (light extinguishing) phenomenon.

For example, when the display device is viewed from an upward angle on the side of the first module (10) and a downward angle on the side of the second module (20), light emitted from the blue light emitting device (23) located at the outermost part of the first module (10) and the red light emitting device (21) located at the outermost part of the second module (11) is not totally reflected at the edge of the modules (10, 11) and may be normally emitted by the light control layer (300).

Accordingly, when viewing the display device from an upward angle on the first module (10) side and a downward angle on the second module (20) side, red, green, and blue may be mixed to produce white light (meanwhile, part A is a part that may be normally implemented as white light by mixing with the light of the neighboring module when the neighboring other modules are disposed consecutively).

In this way, when viewing the display device from the front and from a viewing angle, the light distribution can be evenly achieved without the occurrence of the light brightening/extinction phenomenon by the light control layer (300).

## Claims

1. A display device comprising:
a wiring board;
an electrode pad disposed on the wiring board and defining a plurality of unit sub-pixels;
a plurality of light emitting devices electrically connected to one of the electrode pads and constituting the unit sub-pixels;
an encapsulation layer disposed on the light emitting devices; and
a light control layer disposed on a side end of the encapsulation layer.

2. The display device according to claim 1, wherein the light control layer is configured to control a transmittance of light emitted from a first light emitting device of the plurality of light emitting devices at the side end of the encapsulation layer.

3. The display device according to claim 2, wherein the first light emitting device is disposed adjacent to the side end of the encapsulation layer.

4. The display device according to claim 3, wherein the light control layer is configured to reduce a ratio of light from the first light emitting device adjacent to the side end of the encapsulation layer being totally reflected at the side end of the encapsulation layer.

5. The display device according to any one of claims 1 to 4, wherein the light control layer comprises,
a first layer having a first refractive index;
a second layer having a second refractive index on the first layer; and
a third layer having a third refractive index on the second layer.

6. The display device according to claim 5, wherein at least one of the first to third layers has a refractive index between refractive indices of the encapsulation layer and air.

7. The display device according to claim 6, wherein the third refractive index is identical to the first refractive index.

8. The display device according to claim 6, or 7, wherein the first refractive index of the first layer is smaller than the refractive index of the encapsulation layer.

9. The display device according to claim 6, wherein the second refractive index of the second layer is greater than the refractive index of the encapsulation layer.

10. The display device according to any one of claims 1 to 9, wherein the light control layer comprises an odd number layer which has a different refractive index from other layers.

11. A display device in which a first module and a second module, each having a plurality of unit pixel areas defined, are joined with a boundary portion interposed therebetween,
wherein at least one of the first module or the second module comprises:
an electrode pad disposed in the unit pixel area and defining a plurality of unit sub-pixels;
a plurality of light emitting devices electrically connected to the electrode pad;
an encapsulation layer disposed on the light emitting devices; and
a light control layer disposed on the boundary portion,
wherein at least one portion of the light control layer comprises a refractive index between a refractive index of the encapsulation layer and a refractive index of air.

12. The display device according to claim 11, wherein the light control layer is configured to regulate an emission of light from a light emitting device of the plurality of light emitting devices adjacent to the boundary.

13. The display device according to claim 11, or 12, wherein a pitch of the unit pixel is 1 mm or less.

14. The display device according to claim 11, 12, or 13, wherein the light control layer comprises an odd number layer which has a different refractive index from other layers.

15. The display device according to any one of claims 11 to 14, wherein the light control layer comprises,
a first layer having a first refractive index;
a second layer having a second refractive index on the first layer; and
a third layer having a third refractive index on the second layer, and
wherein at least one of the first to third layers has a refractive index between refractive indices of the encapsulation layer and air.
